# EUROPEAN PATENT APPLICATION

(11) **EP 2 640 172 A1**
(43) Date of publication of application: **18.09.2013**
(21) Application number: 11839337.0
(22) Date of filing: 08.11.2011
(51) Int. Cl.: H05K 3/06, C23C 28/02, C23F 1/02, H05K 1/03, H05K 1/09

(54) **METHOD FOR FORMING CIRCUIT ON FLEXIBLE LAMINATE SUBSTRATE**

(30) Priority: 12.11.2010 JP 2010254162
(71) Applicant: JX Nippon Mining & Metals Corporation, Tokyo 100-8164 (JP)
(72) Inventor: SAKAGUCHI Kazuhiko, Hitachi-city Ibaraki 317-0056 (JP); INAZUMI Hajime, Hitachi-city Ibaraki 317-0056 (JP)
(74) Representative: Liesegang, Eva
(86) International application number: PCT/JP2011/075689
(87) International publication number: WO 2012/063805

(57) **Abstract**

A method for forming a circuit on a flexible laminate substrate, wherein when a circuit is formed using an adhesive-free flexible laminate having a polyimide film that serves as a flexible laminate substrate at least one surface of which is plasma-treated, a tie-coat layer A formed on the polyimide film, a metal conductor layer B formed on the tie-coat layer, and a nickel-copper alloy layer as an alloy layer C on the metal conductor layer, a photoresist is applied on the alloy layer C formed on the metal conductor layer, the photoresist is exposed and developed, the sputter layer C, the metal conductor layer B, and the alloy layer C are removed by etching using the same etching solution so as to retain a circuit portion, and the photoresist of the circuit portion is further removed so as to form the circuit.

## Description

### BACKGROUND

### [Technical Field]

The present invention relates to a method for forming a circuit on a flexible laminate substrate that is used as a packaging material for electronic parts such as flexible printed boards, TABs, and COFs.

An FCCL (Flexible Copper Clad Laminate), in which a metal conductor layer mainly formed from copper is laminated on a polyimide film, is widely used as a material of a circuit board in the electronics industry. Among the above, an adhesive-free flexible laminate (in particular, a two-layer flexible laminate) that does not have an adhesive layer between a polyimide film and a metal layer has been attracting attention pursuant to demands of finer pitches of circuit wiring widths.

As a method for producing an adhesive-free flexible laminate which is particularly capable of having fine pitches, a so-called metalizing method is mainly performed in which a metal layer is formed on a polyimide film, in advance, by a dry plating method such as sputtering, CVD, or vapor deposition, and thereafter forming a metal layer film to become a conductor layer by a wet plating method.
In the metalizing method, in order to increase adhesion between the metal layer and the polyimide film, the polyimide film surface is modified by performing plasma treatment to eliminate the contaminants on the surface and to improve surface roughness prior to metal layer formation (see Patent Literatures 1 and 2).

While the foregoing method is very effective, it has been known that there is a problem in the deterioration of adhesion in terms of long-term reliability due to the heat treatment during circuit formation or the usage environment. Thus, additionally proposed was forming a tie-coat layer that is an intermediate layer on the plasma-treated surface for further improvement of the adhesion between the polyimide film layer and the metal conductor layer. The foregoing formation of a tie-coat layer is an extremely effective method (see Patent Literature 1).

Meanwhile, with an FCCL that is used in TAB, COF, FPC and the like, the metal conductor layer is etched and removed via the subtractive process. Pursuant to even finer pitches of the circuit wiring widths, improving the etch factor to the fine pitch is being considered, especially by applying a semi-additive process, and by performing anisotropic etching with an added inhibitor in the etching solution for etching the metal conductor layer (see Patent Literatures 3 and 4).

In the case of a semi-additive process, it is not possible to directly apply the processes that have been used in the conventional subtractive process. It is not only necessary to perform the plating process of newly forming a metal conductor layer, but also to form a resist that corresponds to the thickness of the metal conductor layer.
An etching solution containing an inhibitor can be applied to a conventional etching line; however, it is unable to resolve the problems: the various circuit wiring widths existing in the same substrate are of different shapes and the linearity of the wiring is inferior due to the thickness of the metal conductor layer or the circuit wiring pitch.

Namely, the problem is that the circuit does not become the intended width when etching and forming the circuit in the process of printing a circuit via the resist application and exposure process for forming the intended circuit and additionally performing etching treatment for removing the unwanted portion of the copper foil.
This means that the copper portion of the post-etching copper foil circuit is etched downward from the surface of the copper layer; that is, etched in a manner of spreading out wide toward the resin layer (results in defective etching). The defective etching hereinafter is called 'sagging'. In the case where severe "sagging" occurs, the copper circuit may short-circuit in the vicinity of the resin substrate, resulting in a defective product.

It is necessary to reduce such "sagging" as much as possible, and in order to prevent such an etching failure from being etched spreading out wide, the inventors came up with reducing such "sagging" by extending etching time to perform more etching.
In the foregoing case, however, if there is a location that has already reached a predetermined width dimension, there is a problem in that such location will be further etched and will cause the circuit width to be narrower by that much, and the uniform line width, or circuit width that is intended in the circuit design cannot be obtained.
Patent Literature 5 proposes formation of a layer of metal or alloy that has a lower etching rate than copper on the metal conductor layer to reduce "sagging". However, although this method can enhance the etch factor, the problem of poor circuit linearity remains. In particular, there is a problem in that such location (thinned portion) will generate heat and, in certain cases, break.

As electronic circuits are being fine-patterned, the foregoing problems caused by such an etching failure still arises even today, and become a major problem in terms of circuit formation.
The inventors invented pre-etching that removes in advance a layer of metal or alloy that has a lower etching rate than copper formed on the metal conductor layer as a means of reducing "sagging" of a circuit and improving circuit linearity (Patent Literature 6). Pre-etching was effective enough to satisfy both properties, however, it was slightly disadvantageous in that it added a pre-etching step to the circuit formation process and that cost increase was inevitable.

[Patent Document 1] Japanese Patent No. 3173511
[Patent Document 2] Japanese Unexamined Patent Application Publication No. 2003-519901
[Patent Document 3] Japanese Unexamined Patent Application Publication No. 2004-256901
[Patent Document 4] Japanese Unexamined Patent Application Publication No. 2009-167459
[Patent Document 5] Japanese Unexamined Patent Application Publication No. 2002-176242
[Patent Document 6] Japanese Patent Application No.JP 2010-035863

### SUMMARY OF THE INVENTION

### [Technical Problem]

An object of the present invention is to provide a method for forming a circuit with favorable wiring linearity while simultaneously inhibiting side etching, which interferes the achievement of finer pitches of circuit wiring by forming a nickel-copper alloy layer on a metal conductor layer of a flexible laminate.

### [Solution to Problem]

In order to achieve the foregoing object, the present invention provides:
1) A method for forming a circuit on a flexible laminate substrate, wherein when a circuit is formed using an adhesive-free flexible laminate having a polyimide film that serves as a flexible laminate substrate at least one surface of which is plasma-treated, a tie-coat layer A formed on the polyimide film, a metal conductor layer B formed on the tie-coat layer, and a nickel-copper alloy layer as an alloy layer C on the metal conductor layer, a photoresist is applied on the alloy layer C formed on the metal conductor layer, the photoresist is exposed and developed, the alloy layer C, the metal conductor layer B, and the tie-coat layer A are removed by etching using the same etching solution to retain a circuit portion, and the photoresist of the circuit portion is further removed so as to form the circuit.

The present invention additionally provides:
2) The method for forming a circuit on a flexible laminate substrate according to 1) above, wherein the layer C formed on the metal conductor layer is a sputter layer having thickness at 1 to 50 nm.
3) The method for forming a circuit on a flexible laminate substrate according to any one of 1) and 2) above, wherein the layer C formed on the metal conductor layer is a nickel-copper alloy containing nickel in an amount of 60 mass% or greater.
4) The method for forming a circuit on a flexible laminate substrate according to any one of 1) to 3) above, wherein the tie-coat layer A is a sputter layer selected from any one of nickel, chromium, cobalt, nickel alloy, chromium alloy, and cobalt alloy having thickness at 5 to 100 nm.
5) The method for forming a circuit on a flexible laminate substrate according to any one of 1) to 4) above, wherein the metal conductor layer B is copper or a copper alloy.

Accordingly, the present invention has remarkable effects that in the adhesive-free flexible laminate in which the tie-coat layer A and the nickel-copper alloy layer C are formed on the lower and upper sides of the metal conductor layer B, respectively, adhesion after thermal aging between the polyimide film and the metal layer can be increased on the tie-coat layer A side, and on the nickel-copper alloy layer C side, i.e., on the upper surface side of the metal conductor layer, side etching is inhibited during circuit formation, and a high etch factor is attained, thus yielding a favorable circuit linearity.

In other words, when forming a circuit by etching the metal conductor layer B of the flexible laminate substrate based on the forgoing configuration, it is possible to prevent the occurrence of sagging caused by etching process, and shorten the time required for forming a circuit via etching.
Also, a remarkable effect of favorable wiring linearity can be attained when the metal conductor layer B is collectively etched using the same etching solution without removing the nickel-copper alloy layer C in advance.

Thus, the present invention yields an effect of being able to provide an adhesive-free flexible laminate for use in an electronic circuit in which an intended circuit that has a more uniform circuit width can be formed, etching properties in pattern etching can be improved, and generation of short circuits and defective circuit width can be prevented.

### BRIEF DESCRIPTION OF DRAWINGS

FIG. 1 is an explanatory diagram showing the cross-section of an adhesive-free flexible laminate including a polyimide film, a tie-coat layer A, a metal conductor layer B, and an alloy layer C.
FIG. 2 is an explanatory diagram showing how to calculate the etch factor.
FIG. 3 is an explanatory diagram showing the steps of application of a photoresist to an adhesive-free flexible laminate, exposure and development of the photoresist, etching of a metal conductor layer, and separation of a photoresist layer.
FIG. 4 is a diagram of Comparative Example 1, showing that the width between circuits is narrow.
FIG. 5 is a diagram of Comparative Example 9, showing circuits where the linearity is subject to disarray.
FIG. 6 is a diagram of Example 1, showing circuits with excellent linearity.

### DETAILED DESCRIPTION OF THE INVENTION

Specific examples of the present invention are now explained. Note that the ensuing explanation it provided to facilitate the understanding of the present invention, and that the present invention shall in no way be limited thereby. That is, other aspects or modifications are encompassed within the present invention.

The adhesive-free flexible laminate of the present invention includes a polyimide film at least one surface of which is plasma-treated, a tie-coat layer A formed thereon, a metal conductor layer B formed on the tie-coat layer A, and a sputter layer on the metal conductor layer B. The surface of the polyimide film is plasma-treated to eliminate contaminants on the surface and modify the surface.
The tie-coat layer A refers to an intermediate layer for increasing adhesion between the polyimide film layer and the metal conductor layer B. The term "tie-coat layer" is used also in the aforementioned Patent Literature 1 (Japanese Patent No. 3173511), and is known as a generally used technical term. Herein, the term "tie-coat layer" is used as necessary.

As the tie-coat layer A, it is possible to use a sputter layer having thickness at 5 to 100 nm selected from any one of nickel, chromium, cobalt, nickel alloy, chromium alloy, and cobalt alloy. All these materials can increase adhesion between the polyimide film layer and the metal conductor layer B, and can be etched in circuit design. The tie-coat layer A is a layer that functions to increase adhesion between the polyimide film layer and the metal conductor layer B.

Nickel alloy, chromium alloy, and cobalt alloy are alloys containing nickel, chromium, or cobalt as the main component (containing them in an amount of 50 mass% or greater), respectively, and accessory components of the alloys are not particularly limited. All existing alloys can be applied. The component composition of a target is directly reflected in a thin film that is formed by sputtering, and a film having the same component can be formed.

The post-lamination initial adhesion between the polyimide film and the metal layer of the adhesive-free flexible laminate in which the tie-coat layer A and the metal conductor layer B are formed on the plasma-treated surface of the polyimide film is generally measured as "ordinary-state peel strength", and this ordinary-state peel strength is not dependent on the roughness of the plasma-treated surface when the plasma-treated surface roughness Rz is within the range of 2.5 to 20 nm. However, when the tie-coat layer A is not provided, the peel strength is lowered by about half.

The appropriate thickness is 5 to 100 nm since the adhesiveness will deteriorate when the thickness is less than 5 nm, and the result will become saturated when the thickness exceeds 100 nm. While the foregoing materials are useful in preparing the adhesive-free flexible laminate, it should be understood, it should be understood that selection of materials other than the aforementioned materials is not denied in the present invention.
Copper or a copper alloy can be used as the metal conductor layer B. This does not also deny selection of other highly conductive materials.

Furthermore, the present invention is unique with respect to the layer C formed on the metal conductor layer B. Preferably, used as the layer C may be a nickel-copper alloy layer.
As described in Patent Literature 5, the layer C formed on the metal conductor layer B functions to inhibit side etching on the metal conductor layer B during circuit formation, prevent sagging and thus enable a high etch factor to be achieved. A nickel alloy is described as being effective.

However, Patent Literature 5 is silent on circuit linearity. In the experiments conducted by the inventors, good results are not obtained using a Ni layer, Co layer, or NiCr layer. A feature of the present invention is to have recognized a nickel-copper alloy for use as a layer C that yields a high etch factor and favorable circuit linearity out of a large number of Ni alloys. This recognition was discovered for the first time in the present invention.

Also, in the present invention, desirably, the alloy layer C is formed by sputtering since sputtering allows a thin layer having a uniform composition to be formed. In the present invention, the thickness at 1 to 50 nm is appropriate, since the effect is small at the thickness less than 1 nm, while the effect saturates at the exceeding 50 nm. As for the composition of the alloy layer C, it is desirable that Ni is contained in an amount of 60 mass% or greater, and the alloy layer C is preferably formed by sputtering because adjustment of the composition is ensured in the composition of the target.
It is possible to form a circuit having favorable wiring linearity without pre-etching the alloy layer C. This is one great feature of the present invention.

When the adhesive-free flexible laminate of the present invention is produced, at least one surface of the polyimide film is plasma-treated by glow discharge, then the tie-coat layer A is formed by sputtering, next the metal conductor layer B is formed on the tie-coat layer, and the nickel-copper alloy layer C is formed on the metal conductor layer B by sputtering.
Specifically, it is possible to form the tie-coat layer A having thickness at 5 to 100 nm by performing sputtering on the plasma-treated surface using a target material selected from any one of nickel, chromium, cobalt, nickel alloy, chromium alloy, and cobalt alloy. As described above, copper or a copper alloy can be used as the metal conductor layer B.

Moreover, when the adhesive-free flexible laminate of the present invention is produced, specifically, it is possible to form the layer C having thickness at 1 to 50 nm on the metal conductor layer B by sputtering using a target material formed from a nickel-copper alloy.
This layer inhibits side etching on the metal conductor layer B during circuit formation, prevents occurrence of sagging and thus yields a high etch factor.

Photoresist is foremost applied on the upper surface side of the metal conductor layer B, a circuit pattern is thereafter exposed and developed to have a circuit pattern, and then subject to the etching process. Generally, relative to an etching solution such as ferric chloride or copper chloride, the sputter layer C of the present invention is thin at 1 to 50 nm, and, other than the metal or alloy of the sputter layer C itself dissolving, as a result of the etching solution infiltrating the sputter layer, the separation at the interface of the metal conductor layer B and the sputter layer is promoted, and the sputter layer is removed as a film from the resist opening during etching.

However, if the alloy layer C is formed from a nickel alloy other than a nickel-copper alloy, the alloy layer C may exhibit poor solubility in an etching solution such as ferric chloride or cupric chloride, and in such a case, the etching solution that has infiltrated the alloy layer C may dissolve the metal conductor layer B first, etching occurring in a non-uniform manner from place to place. As a result, circuit linearity may be deteriorated.

On the other hand, when a nickel-copper alloy is used as the alloy layer C, a high etch factor and favorable circuit linearity appear.

According to the present invention, side etching of the metal conductor layer B caused by an etching solution is suppressed in the etching step by the alloy layer C present between the resist and the metal conductor layer B, thus enabling anisotropic etching as a result. This is the main reason for a high etch factor.

### Examples

Next, the present invention will now be described by way of examples and comparative examples. Note that examples merely provide an embodiment, and that the present invention is not limited to this embodiment. That is, other aspects and modifications are encompassed within the present invention. Comparative examples will also be similarly described for comparison.

A material used as a polyimide film is not particularly limited. For example, Upilex manufactured by Ube Industries Ltd., Kapton manufactured by Du Pont-Toray Co., Ltd., and Apical manufacture by Kaneka Corporation are commercially available, and the present invention is applicable to all these polyimide films. The applicability is not limited to such specific products. In the examples and comparative examples, Upilex-SGA manufactured by Ube Industries Ltd., was used as a polyimide film.
First, a polyimide film was placed in a vacuum device and evacuated. Then, oxygen was introduced into the chamber, the chamber pressure was adjusted to 10 Pa, and plasma treatment was thereby performed.

Next, by sputtering, a tie-coat layer A having thickness varying in the range of 0 to 50 nm was formed on the plasma-treated polyimide film surface, and a 300 nm copper layer was formed on the tie-coat layer A. Moreover, a metal conductor layer B (having thickness at 8.5 µm) formed from copper was formed by electroplating on the tie-coat layer A and the copper layer thereon, thus preparing an adhesive-free flexible laminate.
An alloy layer C having thickness at 1 to 50 nm was further formed on the metal conductor layer B surface of this adhesive-free flexible laminate by sputtering.

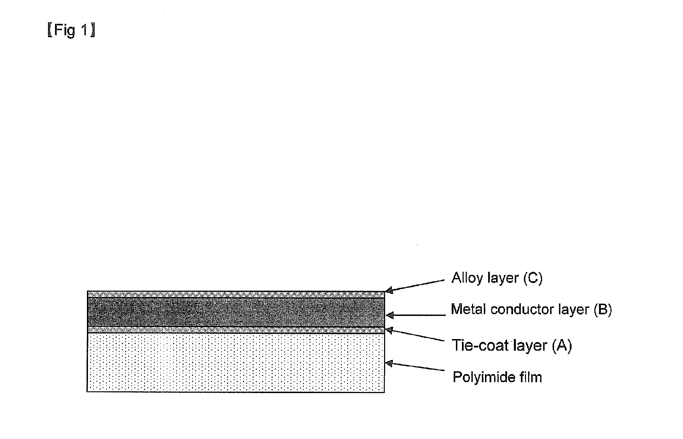

FIG. 1 shows the cross-section of the adhesive-free flexible laminate. As shown in FIG. 1, the adhesive-free flexible laminate includes a polyimide film, tie-coat layer A, a metal conductor layer B, and alloy layer C. Next, a sample was provided to evaluate the etch factor.
A liquid resist was applied to a sample and dried. Then, using a glass mask with a 30 µm pitch on which a circuit with a 21 µm line and a 9 µm space had been drawn, exposure and development and drying were performed. Thereafter, etching was performed, and the etch factor was evaluated.

Ferric chloride and cupric chloride are applicable to etching of the metal conductor layer B. With respect to these etching solutions, the tie-coat layer A and the alloy layer C can be etched with the same etching solution, and in the examples and comparative examples, ferric chloride (40° Baume, 50°C) and cupric chloride (2 mol/L, hydrochloric acid 3 mol/L, 50°C) were used.

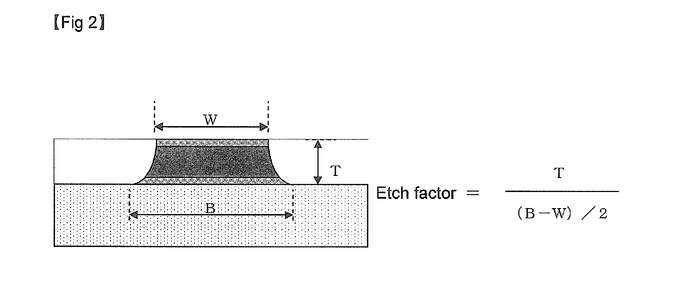

The etch factor can be defined as shown in FIG. 2. As shown, the calculation method of the etch factor is T/((B-W)/2).
Results of etch factor evaluation are shown in Table 1. The etching time varies depending on the sample in order to arrange the top width (W) of the circuit wiring width so as to be 8 ± 1 µm.
Since the side etching will simultaneously occur even when the etching solution that infiltrated from the resist opening having a space of 9µm causes etching to advance toward the bottom, when etching is performed up to a certain level of the top width, samples with a low etch factor will have a large bottom width (B).

Meanwhile with respect to a sample that inhibits side etching, etching in the bottom direction proceeds preferentially, and therefore the difference between the top width (W) and bottom width (B) is small.
For circuit linearity evaluation, the circuit shape is observed using an optical microscope or scanning electron microscope at 50-fold magnification, and the circuit pitch (P) and the top width (W) at random 10 points within a 100 µm × 100 µm range in the observed image are measured. Linearity is expressed as (P-W)/T using the copper thickness (T) as shown in FIG. 2. The smaller the variation in the numerical value is, the better the circuit linearity is. In Table 1, as an indicator of a favorable/poor linearity, the standard deviation of (P-W)/T at 10 points was showed. In the present invention, a standard deviation of 0.1 or less was regarded as being favorable.

**[Table 1]**

| | Type of sputtered layer C | Thickness of sputtered layer C(nm) | Cupper thickness B [T] (mm) | Type of tie-coat layer A | Thickness of tie-coat layer A (nm) | Etching solution | Top width [W] (mm) | Bottom width [B] (mm) | Etch factor | Standard deviation (P-W)/T |
|---|---|---|---|---|---|---|---|---|---|---|
| Comparative Example 1 | None | 0 | 8.5 | NiCr (80/20) | 10 | Ferric chloride | 7.0 | 16.6 | 1.78 | 0.079 |
| Comparative Example 2 | None | 0 | 8.5 | NiCr (80/20) | 10 | Cupric chloride | 7.4 | 16.2 | 1.92 | 0.096 |
| Comparative Example 3 | NiCr (80/20) | 10 | 8.5 | NiCr (80/20) | 10 | Ferric chloride | 8.8 | 12.1 | 5.13 | 0.155 |
| Comparative Example 4 | NiCr (80/20) | 30 | 8.5 | NiCr (80/20) | 10 | Ferric chloride | Circuit formation impossible | Circuit formation impossible | - | - |
| Comparative Example 5 | NiCr (93/7) | 10 | 8.5 | NiCr (80/20) | 10 | Ferric chloride | 8.5 | 12.9 | 3.85 | 0.127 |
| Comparative Example 6 | NiCr (80/20) | 10 | 8.5 | NiCu (67/33) | 10 | Ferric chloride | 8.5 | 11.8 | 5.13 | 0.149 |
| Comparative Example 7 | CuNi (75/25) | 10 | 8.5 | NiCr (80/20) | 10 | Ferric chloride | 7.7 | 16.2 | 2.01 | 0.087 |
| Comparative Example 8 | NiCu (55/45) | 10 | 8.5 | NiCr (80/20) | 10 | Ferric chloride | 7.7 | 13.6 | 2.89 | 0.097 |
| Comparative Example 9 | Ni plating | 10 | 8.5 | NiCr (80/20) | 10 | Ferric chloride | 8.5 | 11.8 | 5.13 | 0.166 |
| Example1 | NiCu (67/33) | 10 | 8.5 | NiCr (80/20) | 10 | Ferric chloride | 8.5 | 11.4 | 5.77 | 0.078 |
| Example2 | NiCu (67/33) | 50 | 8.5 | NiCr (80/20) | 10 | Ferric chloride | 8.8 | 11.4 | 6.60 | 0.093 |
| Example3 | NiCu (67/33) | 50 | 8.5 | NiCr (80/20) | 10 | Cupric chloride | 8.5 | 11.0 | 6.60 | 0.096 |
| Example4 | NiCu (67/33) | 10 | 8.5 | NiCu (67/33) | 10 | Ferric chloride | 8.1 | 11.4 | 5.13 | 0.087 |

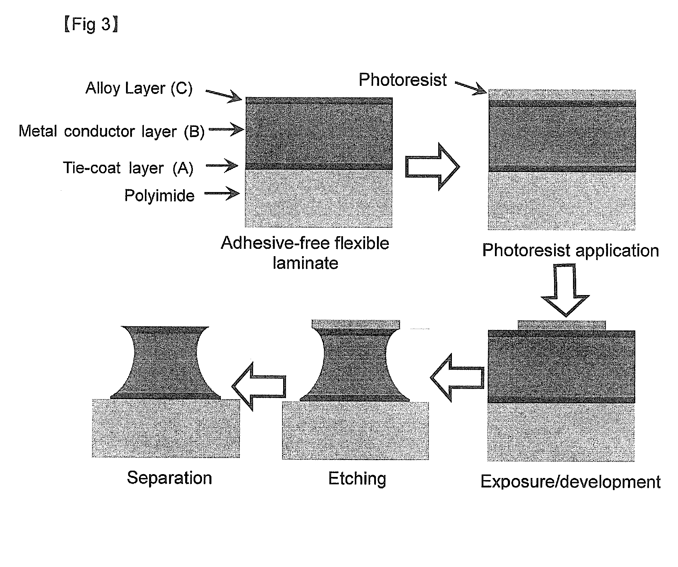

FIG. 3 is a diagram showing the etching process in the examples. As shown in FIG. 3, the etching process includes the steps of application of a photoresist to an adhesive-free flexible laminate, exposure and development of the photoresist, etching, and separation of the photoresist layer.

### (Comparative Example 1)

Comparative Example 1 has a 30 µm pitch with 21/9, a 10 nm nickel-chromium alloy (Ni/Cr = 80/20) tie-coat layer A, an 8.5 µm copper metal conductor layer B, and no alloy layer C. In the case of etching with ferric chloride, the side surfaces of the circuit were etched in a manner spreading wide toward the bottom, with the top width (T) being 7.0 µm, the bottom width (B) being 16.6 µm, and the etch factor being 1.78. The standard deviation of (P-W)/T was 0.079, thus being no greater than 0.1. Therefore, the circuit linearity was favorable, but the etch factor was poor. Results are shown in Table 1.

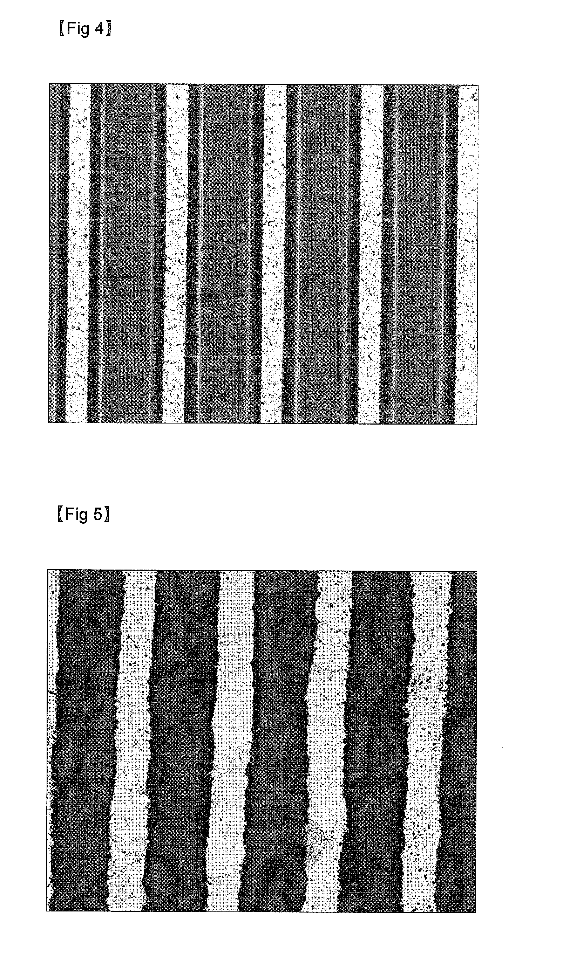

FIG. 4 (photograph) shows a circuit formed by etching. As shown in FIG. 4, it can be observed that the width between circuits is narrow because of "sagging", but the circuit linearity is favorable.

### (Comparative Example 2)

Comparative Example 2 is a case where ferric chloride used in Comparative Example 1 is replaced with cupric chloride. In this case, the side surfaces of the circuit were etched in a manner spreading wide toward the bottom, with the top width being 7.4 µm, the bottom width being 16.2 µm, and the etch factor being 1.92. The standard deviation of (P-W)/T was 0.096, thus being no greater than 0.1. Therefore, the circuit linearity was favorable, but the etch factor was poor. Also, in the case where a surface-treated layer was not provided, no large differences in etch factor or standard deviation of (P-W)/T were observed even when a different etching solution was used. Results are shown in Table 1.

### (Comparative Example 3)

Comparative Example 3 is the same as Comparative Example 1 except that a 10 nm nickel-chromium alloy (Ni/Cr = 80/20) is used for the alloy layer C. As a result, the top width was 8.8 µm, the bottom width was 12.1 µm, and the etch factor was high at 5.13, thus an effect of increasing the etch factor obtained due to the alloy layer C, but on the other hand, the standard deviation of (P-W)/T was 0.155, resulting in a poor circuit linearity. Results are shown in Table 1.

### (Comparative Example 4)

Comparative Example 4 is a case where the alloy layer C used in Comparative Example 3 has thickness at 30 nm. In this case, thickening the alloy layer C required longer dissolution and separation times. As a result, when the alloy layer disappeared, dissolution of the copper foil had already proceeded, which caused a phenomenon of a circuit flowing away. It was impossible to form a circuit and to evaluate the etch factor or circuit linearity. Results are shown in Table 1.

### (Comparative Example 5)

Comparative Example 5 is a case where the alloy layer C used in Comparative Example 3 is a 10 nm nickel-chromium alloy (Ni/Cr = 93/7). As a result, the top width was 8.5 µm, the bottom width was 12.9 µm, the etch factor was 3.85, and the standard deviation of (P-W)/T was 0.127. Since the nickel alloy comprised less Cr than the nickel alloy used in Comparative Example 3, the circuit linearity was superior to in Comparative Example 3, but inferior to in Comparative Example 1. Results are shown in Table 1.

### (Comparative Example 6)

Comparative Example 6 is a case where the tie-coat layer A used in Comparative Example 3 is a 10 nm nickel-copper alloy (Ni/Cu = 67/33), and where the alloy layer C is a 10 nm nickel alloy (Ni/Cr = 80/20). As a result, the top width was 8.5 µm, the bottom width was 11.8 µm, the etch factor was 5.13, and the standard deviation of (P-W)/T was 0.149. When the tie-coat layer A was a nickel-copper alloy, an effect of increasing the etch factor was obtained due to the alloy layer C, but a phenomenon where the linearity of the circuit deteriorated was observed. Results are shown in Table 1.

### (Comparative Example 7)

Comparative Example 7 is a case where the alloy layer C used in Comparative Example 3 is a 10 nm copper-nickel alloy (Cu/Ni = 75/25). As a result, the top width was 7.7 µm, the bottom width was 16.2 µm, the etch factor was 2.01, and the standard deviation of (P-W)/T was 0.087. Since a nickel-containing copper alloy was used in place of the alloy layer C of Comparative Example 3, the circuit linearity was better than in Comparative Example 3, but no effect of increasing the etch factor was obtained. Results are shown in Table 1.

### (Comparative Example 8)

Comparative Example 8 is a case where the alloy layer C used in Comparative Example 7 is a 10 nm nickel-copper alloy (Ni/Cu = 55/45). As a result, the top width was 7.7 µm, the bottom width was 12.1 µm, the etch factor was 2.89, and the standard deviation of (P-W)/T was 0.097. Since a nickel-rich nickel-containing copper alloy was used in place of the alloy layer C of Comparative Example 7, the etch factor was slightly better than in Comparative Example 7 but smaller than in Comparative Examples 3 and 5 where the alloys had a richer nickel content. Results are shown in Table 1.

### (Comparative Example 9)

Comparative Example 9 is a case where the alloy layer C used in Comparative Example 3 was a 10 nm copper-plated layer. As a result, the top width was 8.5 µm, the bottom width was 11.8 µm, the etch factor was 5.13, and the standard deviation of (P-W)/T was 0.166. Since a nickel-plated layer was used in place of the alloy layer C of Comparative Example 3, and a phenomenon where the linearity of the circuit deteriorated was observed while the etch factor was similar to that in Comparative Example 3. Results are shown in Table 1.
FIG. 5 (photograph) shows a state of the circuit formed by etching of Comparative Example 9. As shown in FIG. 5, the circuit, of which linearity being subject to disarray, is deteriorated.

### (Example 1)

Example 1 is the same as Comparative Example 3 except that a 10 nm nickel-copper alloy (Ni/Cu = 67/33) is used for the alloy layer C. As a result, the top width was 8.5 µm, the bottom width was 11.4 µm, the etch factor was high at 5.77, and the standard deviation of (P-W)/T was 0.078. An effect of increasing the etch factor was obtained and the circuit linearity was favorable due to the alloy layer C. Results are shown in Table 1.

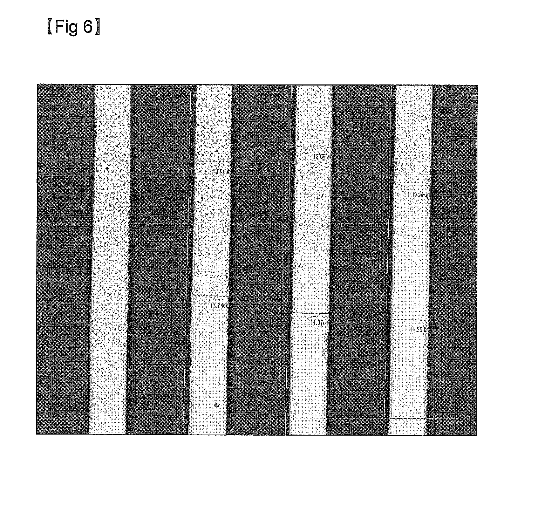

FIG. 6 (photograph) shows a circuit formed by etching of Example 1. As shown in FIG. 6, it was observed that the circuit has an excellent circuit linearity with little "sagging", and that the difference between the bottom width and the top width is small.

### (Example 2)

Example 2 is the same as Example 1 except that a 50 nm nickel-copper alloy (Ni/Cu = 67/33) is used for the alloy layer C. As a result, the top width was 8.8 µm, the bottom width was 11.4 µm, the etch factor was high at 6.60, and the standard deviation of (P-W)/T was 0.093. An effect of increasing the etch factor was obtained due to the alloy layer C, and the circuit linearity was favorable. Results are shown in Table 1.

### (Example 3)

Example 3 is the same as Example 2 except that the etching solution is cupric chloride. As a result, the top width was 8.5 µm, the bottom width was 11.0 µm, the etch factor was high at 6.60, and the standard deviation of (P-W)/T was 0.096. Even when the etching solution was changed, an effect of increasing the etch factor was obtained and the circuit linearity was favorable due to the alloy layer C. Results are shown in Table 1.

### (Example 4)

Example 4 is the same as Example 1 except that a 10 nm nickel-copper alloy (Ni/Cu = 67/33) is used for the tie-coat layer A. That is, the tie-coat layer A and the alloy layer C had the same composition and thickness. As a result, the top width was 8.1 µm, the bottom width was 11.4 µm, the etch factor was high at 5.13, and the standard deviation of (P-W)/T was 0.087. An effect of increasing the etch factor was obtained and the circuit linearity was favorable due to the alloy layer C. Results are shown in Table 1.

### [Industrial Applicability]

The present invention has effects of being able to inhibit side etching during circuit formation and to attain a high etch factor and favorable circuit linearity in an adhesive-free flexible laminate in which nickel-copper alloy layers are formed as a tie-coat layer A and an alloy layer C on the lower and upper sides of a metal conductor layer B, respectively. Thereby, the present invention has remarkable effects of being able to prevent occurrence of sagging when circuit formation is performed by etching, thus to reduce the time of the circuit formation by etching, and to improve the circuit linearity. The present invention yields effects of being able to provide an adhesive-free flexible laminate for use in an electronic circuit with which an intended circuit that has a more uniform circuit width can be formed, etching properties in pattern etching can be improved, and with which generation of short circuits and circuit width defects can be prevented, and therefore the present invention is useful as a flexible laminate substrate that is used as a packaging material for electronic parts such as flexible printed boards, TABs, and COFs.

## Claims

1. A method for forming a circuit on a flexible laminate substrate, wherein when a circuit is formed using an adhesive-free flexible laminate having a polyimide film that serves as a flexible laminate substrate at least one surface of which is plasma-treated, a tie-coat layer A formed on the polyimide film, a metal conductor layer B formed on the tie-coat layer, and a nickel-copper alloy layer as an alloy layer C on the metal conductor layer, a photoresist is applied on the alloy layer C formed on the metal conductor layer, the photoresist is exposed and developed, the alloy layer C, the metal conductor layer B, and the tie-coat layer A are removed by etching using the same etching solution to retain a circuit portion, and the photoresist of the circuit portion is further removed so as to form the circuit.

2. The method for forming a circuit on a flexible laminate substrate according to claim 1, wherein the layer C formed on the metal conductor layer is a sputter layer having thickness at 1 to 50 nm.

3. The method for forming a circuit on a flexible laminate substrate according to any one of claims 1 and 2, wherein the layer C formed on the metal conductor layer is a nickel-copper alloy containing nickel in an amount of 60 mass% or greater.

4. The method for forming a circuit on a flexible laminate substrate according to any one of claims 1 to 3, wherein the tie-coat layer A is a sputter layer selected from any one of nickel, chromium, cobalt, nickel alloy, chromium alloy, and cobalt alloy having thickness at 5 to 100 nm.

5. The method for forming a circuit on a flexible laminate substrate according to any one of claims 1 to 4, wherein the metal conductor layer B is copper or a copper alloy.
